(19) 

Europäisches
Patentamt
European
Patent Office
Office européen
des brevets

(11) **EP 2 384 026 B1**

(12) **EUROPEAN PATENT SPECIFICATION**

(45) Date of publication and mention
of the grant of the patent:
**13.06.2018 Bulletin 2018/24**

(51) Int Cl.:
***H04R 19/04*** (2006.01)

(21) Application number: **11162922.6**

(22) Date of filing: **19.04.2011**

(54) **Acoustic sensor and method of manufacturing the same**

Akustiksensor und Herstellungsverfahren dafür

Capteur acoustique et son procédé de fabrication

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **28.04.2010 JP 2010104193**

(43) Date of publication of application:
**02.11.2011 Bulletin 2011/44**

(73) Proprietor: **Omron Corporation
Kyoto-shi, Kyoto 600-8530 (JP)**

(72) Inventors:
 • **Kasai, Takashi
   Kyoto-shi, Kyoto 600-8530 (JP)**

 • **Tsurukame, Yoshitaka
   Kyoto-shi, Kyoto 600-8530 (JP)**
 • **Moon, Seung Kae
   Kyoto-shi, Kyoto 600-8530 (JP)**
 • **Terasaka, Shinichi
   Kyoto-shi, Kyoto 600-8530 (JP)**

(74) Representative: **Kilian Kilian & Partner
Aidenbachstraße 54
81379 München (DE)**

(56) References cited:
**US-A1- 2008 104 825    US-A1- 2009 092 273
US-A1- 2010 038 734**

**Description**

BACKGROUND OF THE INVENTION

1. TECHNICAL FIELD

The present invention relates to acoustic sensors and methods for manufacturing the same. Specifically, the present invention relates to an MEMS (Micro Electro Mechanical Systems) type acoustic sensor, and a method for manufacturing the acoustic sensor using the MEMS technique.

2. RELATED ART

An electret capacitor microphone and an MEMS microphone are used for a miniature microphone, and the present invention relates to an acoustic sensor (microphone chip) used in the MEMS microphone manufactured using the MEMS technique. First, the conventional acoustic sensor related to the present invention will be described.

(General acoustic sensor MEMS type of prior art)

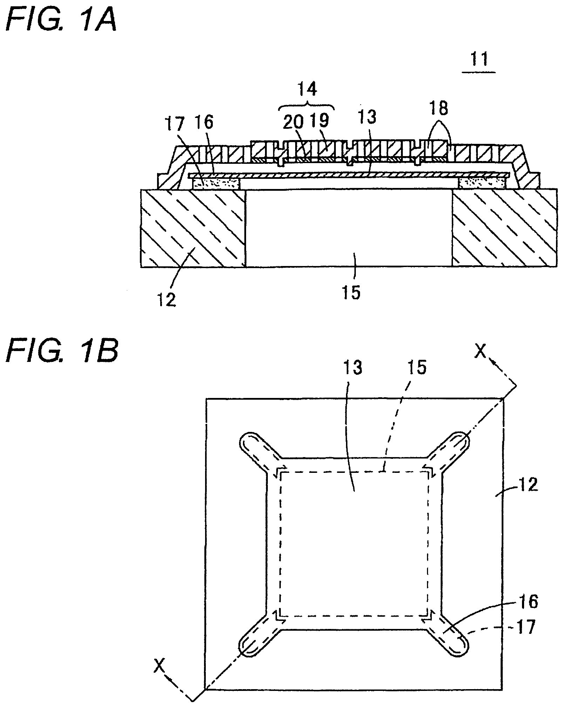

Fig. 1A is a cross-sectional view in a diagonal direction of a conventional acoustic sensor 11 of the MEMS type (cross-sectional view taken along line X-X of Fig. 1B), and Fig. 1B is a plan view in a state a back plate is removed in the acoustic sensor 11. The acoustic sensor 11 is mainly configured by a silicon substrate 12 made of monocrystal silicon, a diaphragm 13 made of polysilicon, and a back plate 14. A back chamber 15 is opened in the silicon substrate 12 to pass therethrough, and the diaphragm 13 is arranged on an upper surface of the silicon substrate 12 so as to cover the upper side of the back chamber 15. The diaphragm 13 has a substantially square shape, where a beam portion 16 extends outward in the diagonal direction from each corner. Each beam portion 16 is fixed to the upper surface of the silicon substrate 12 by an anchor 17 arranged on the lower surface of the beam portion, and the diaphragm 13 floats from the upper surface of the silicon substrate 12 by the anchor 17.

The diaphragm 13 is covered by the back plate 14 fixed on the upper surface of the silicon substrate 12, and a great number of acoustic holes 18 (acoustic perforations) for passing the acoustic vibration is opened in the back plate 14. The back plate 14 includes a fixed electrode film 20 made of polysilicon on an inner surface of a plate portion 19 having high rigidity made of SiN.

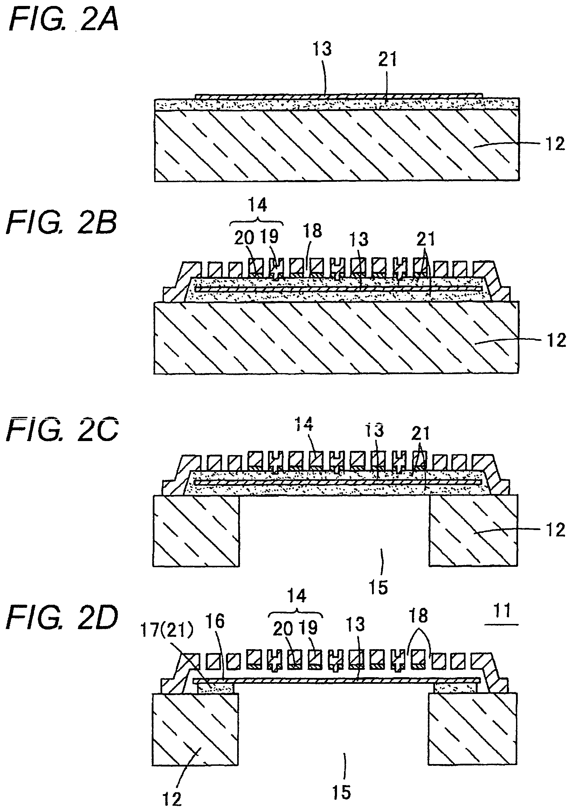

The acoustic sensor 11 is manufactured through the manufacturing processes, for example, as shown in Fig. 2A to Fig. 2D (line appearing on the far side of the cross-section is sometimes omitted to facilitate the understanding in the cross-sectional views after Figs. 2A to 2D) using the MEMS technique. As shown in Fig. 2A, a sacrifice layer 21 ($SiO_2$ layer) is stacked on the upper surface of the silicon substrate 12, a polysilicon thin film is formed thereon, and the polysilicon thin film is etched to a predetermined diaphragm shape to form the diaphragm 13.

The sacrifice layer 21 ($SiO_2$ layer) is further stacked on the diaphragm 13 and the sacrifice layer 21 to cover the diaphragm 13 with the sacrifice layer 21, and then the sacrifice layer 21 is etched in accordance with the inner surface shape of the back plate 14. A polysilicon layer is formed on the sacrifice layer 21, and such polysilicon layer is etched to a predetermined fixed electrode film shape to form the fixed electrode film 20. Thereafter, as shown in Fig. 2B, a SiN layer is stacked on the fixed electrode film 20 and the sacrifice layer 21, and the SiN layer is etched to a predetermined shape to form the plate portion 19. A great number of acoustic holes 18 are opened in the back plate 14 including the plate portion 19 and the fixed electrode film 20.

Subsequently, as shown in Fig. 2C, a central part of the silicon substrate 12 is selectively etched from the lower surface side to pass the back chamber 15 through the silicon substrate 12, so that the sacrifice layer 21 is exposed at the upper surface of the back chamber 15.

Thereafter, the sacrifice layer 21 is subjected to wet etching through the acoustic holes 18 of the back plate 14, the back chamber 15 of the silicon substrate 12, and the like, so that only the sacrifice layer 21 under the beam portion 16 remains as the anchor 17 and the other sacrifice layer 21 is removed, as shown in Fig. 2D. As a result, the diaphragm 13 floats from the upper surface of the silicon substrate 12 by the anchor 17 and is supported to be able to vibrate on the back chamber 15, whereby an air gap is formed between the fixed electrode film 20 and the diaphragm 13.

In such acoustic sensor 11, the beam portion 16 is extended from the diaphragm 13 and the beam portion 16 is fixed to the silicon substrate 12 by the anchor 17 formed by leaving one part of the sacrifice layer to increase the displacement of the diaphragm 13 due to sound pressure and enhance the sensitivity of the diaphragm 13. In order to further enhance the sensitivity of the diaphragm 13, the beam portion 16 is desirably made longer and the anchor 17 is desirably positioned distant from the edge of the back chamber 15, and the length of the portion of the beam portion 16 not fixed with the anchor 17 is desirably made longer.

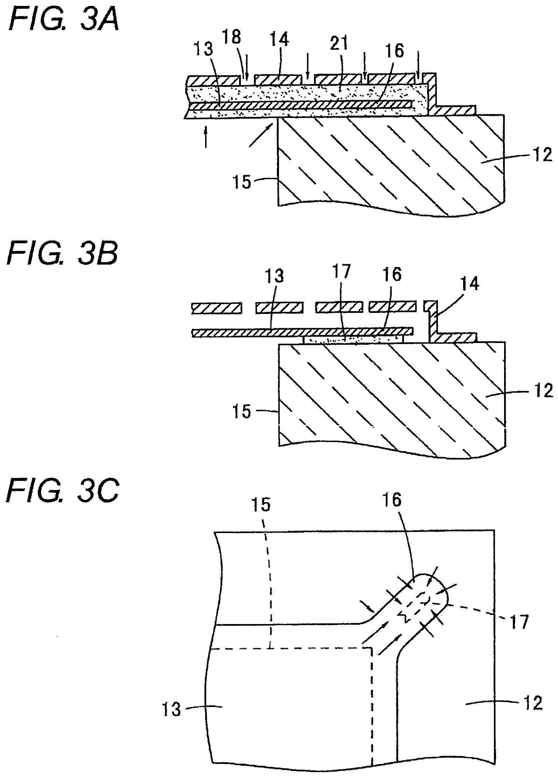

However, the sacrifice layer 21 is etched with an etchant infiltrated from the acoustic holes 18 or an etchant introduced from the back chamber 15 as shown with arrows in Fig. 3A, and the anchor 17 is formed by the sacrifice layer 21 left under the beam portion 16 as shown in Fig. 3B. The anchor 17 thus also becomes long if the beam portion 16 is made long, and hence the length of the portion of the beam portion 16 not fixed with the anchor17 cannot be increased. Furthermore, the anchor 17 becomes thin and short if the etching time is extended in an attempt to position the anchor 17 distant from the edge of the back chamber 15 since the sacrifice layer 21 under the beam portion 16 also gets etched from the side surface as shown in Fig. 3C, and hence the beam portion 16 cannot be supported with the anchor 17.

(Acoustic sensor of Japanese Unexamined Patent Publication No. 2009-89097)

The acoustic sensor in which the length of the portion of the beam portion not fixed with the anchor is increased is disclosed in Japanese Unexamined Patent Publication No. 2009-89097. In the acoustic sensor of Japanese Unexamined Patent Publication No. 2009-89097, the length of the portion of the beam portion not fixed with the anchor is increased by opening a plurality of through-holes at the portion of the beam portion not fixed with the anchor, and increasing the area at the end of the beam portion. Problems will be described below for a case where the through-holes are opened at the portion of the beam portion not fixed with the anchor and for a case where the area at the end of the beam portion is increased.

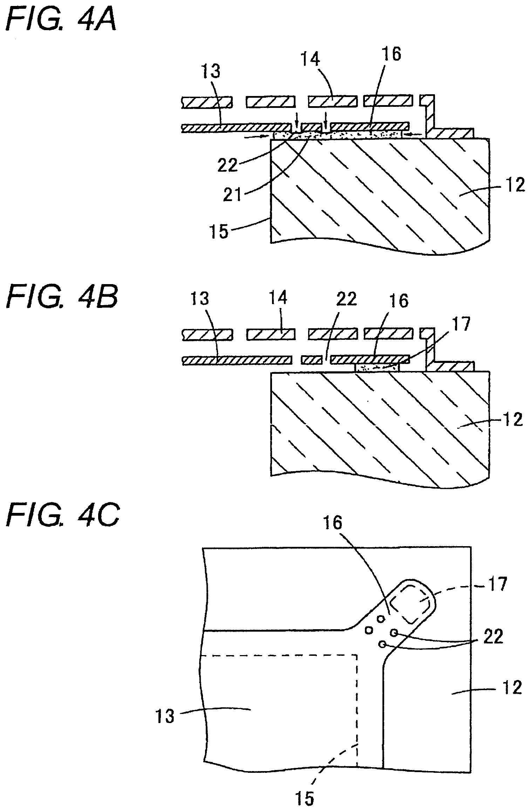

Figs. 4B and 4C are a cross-sectional view and a plan view schematically showing the beam portion 16 formed with a plurality of through-holes 22 at the portion not fixed with the anchor 17. If the through-holes 22 are formed in the beam portion 16, the sacrifice layer 21 at the lower surface of the beam portion 16 will be etched by the etchant infiltrated from the through-holes 22, as shown in Fig. 4A when the sacrifice layer 21 is etched. Therefore, the sacrifice layer 21 remains only at the end where the through-hole 22 is not formed, and the anchor 17 is formed at the end of the beam portion 16, as shown in Figs. 4B and 4C.

However, if the through-holes 22 are formed in the beam portion 16, the mechanical strength of the beam portion 16 may lower, and the beam portion 16 may break at the time of drop test or when a device incorporating the acoustic sensor is dropped.

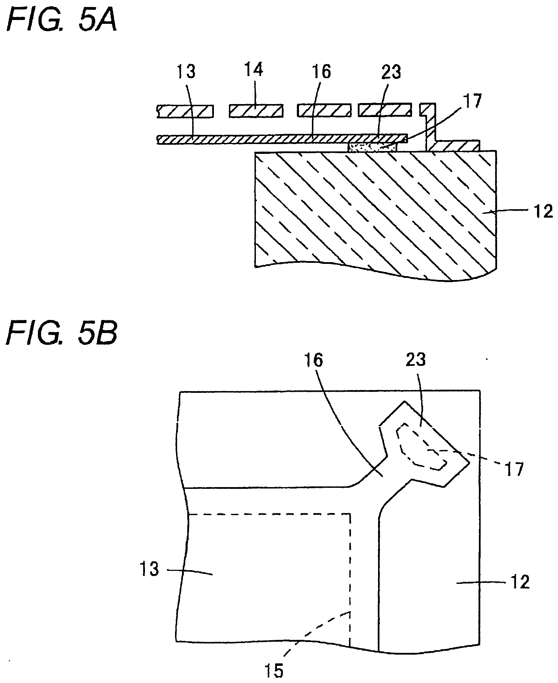

Figs. 5A and 5B are a cross-sectional view and a plan view schematically showing the beam portion 16 in which the area at the end 23 is increased. According to such structure, the sacrifice layer remains at the end 23 even after the sacrifice layer is removed in a region other than the end of the beam portion 16, and hence the anchor 17 can be formed at the end 23 of the diaphragm 13.

In such structure, however, the miniaturization of the acoustic sensor may be inhibited as the area of the beam portion 16 increases. Furthermore, the area of the anchor 17 becomes small compared to the area of the end 23 since the sacrifice layer other than the end 23 needs to be completely removed, and hence the support of the diaphragm 13 may become unstable.

A further prior art document is US 2010/0038734 A1, which discloses a vibration sensor and a method for manufacturing the vibration sensor. The method includes forming a sacrifice layer at one part of a front surface of a semiconductor substrate of monocrystalline silicon with a material isotropically etched by an etchant for etching the semiconductor substrate, forming a thin film protective film with a material having resistance to the etchant on the sacrifice layer and the front surface of the semiconductor substrate at a periphery of the sacrifice layer, forming a thin film of monocrystalline silicon, polycrystalline silicon, or amorphous silicon on an upper side of the sacrifice layer, opening a backside etching window in a back surface protective film having resistance to the etchant for etching the semiconductor substrate formed on a back surface of the semiconductor substrate; forming a through-hole in the semiconductor substrate by etching the semiconductor substrate anisotropically by using crystal-oriented etching by applying the etchant from the back surface window, then etching the sacrifice layer isotropically by the etchant after the etchant reaches the front surface of the semiconductor substrate, and then etching the semiconductor substrate anisotropically by using crystal-oriented etching from a front side by the etchant spread to a space formed after the sacrifice layer is removed, and forming a holder for supporting the thin film on an upper surface of the semiconductor substrate by removing the thin film protective film partially.

SUMMARY

The present invention has been devised to solve the problems described above, and an object thereof is to provide an acoustic sensor capable of increasing the length of the portion of the beam portion not fixed with the anchor without lowering the strength of the beam portion and the supporting strength of the diaphragm. This object is achieved by the subject-matter of claims 1 and 5. Further advantageous embodiments of the invention are the subject-matter of the dependent claims. Aspects of the invention are set out below.

In accordance with the present invention, there is provided a manufacturing method of an acoustic sensor, including a semiconductor substrate with a back chamber, a vibration thin film arranged on an upper side of the semiconductor substrate, an anchor arranged on an upper surface of the semiconductor substrate, a beam portion being integrally extended from the vibration thin film and having a distal end supported by the anchor, and a back plate fixed to the upper surface of the semiconductor substrate to cover the vibration thin film and the beam portion with a space, for converting an acoustic vibration detected by the vibration thin film to change in electrostatic capacitance between a fixed electrode film arranged on the back plate and the vibration thin film, the manufacturing method including the steps of: forming a first sacrifice layer and a second sacrifice layer between a surface of the semiconductor substrate and a lower surface of the vibration thin film and the beam portion to cover at least one of the lower surface of the beam portion or a region facing the beam portion in the semiconductor substrate with the second sacrifice layer, forming an anchor layer between the distal end of the beam portion and the semiconductor substrate separate from the first sacrifice layer with the same material as the first sacrifice layer, covering an upper surface of the vibration thin film and the beam portion with the second sacrifice layer and arranging the vibration thin film and the beam portion in a sacrifice layer including the first sacrifice layer and the second sacrifice layer; forming the back plate on the sacrifice layer; forming the back chamber in the semiconductor substrate; removing the first sacrifice layer by etching; and removing one part of the second sacrifice layer by etching after removing the first sacrifice layer by etching and forming the anchor between a lower surface of the distal end of the beam portion and the surface of the semiconductor substrate from the remaining second sacrifice layer and the anchor layer.

In a manufacturing method of an acoustic sensor according to the present invention, a hollow portion can be formed in a sacrifice layer by removing a first sacrifice layer through etching in advance, so that the etching area of a second sacrifice layer can be controlled by guiding the etchant to an arbitrary position from such hollow portion. Therefore, an anchor can be arranged at the distal end of the beam portion, the region not fixed with the anchor in the beam portion can be made long, and the sensitivity of the acoustic sensor can be enhanced. Furthermore, the anchor layer can be formed at the same time as the first sacrifice layer since it is the same material as the first sacrifice layer, the surface of the second sacrifice layer can be made flat to flatten the beam portion, and the strength of the beam portion can be enhanced. As the height of the anchor increases, the parasitic capacitance in the anchor can be reduced.

In one aspect of the manufacturing method of the acoustic sensor according to the present invention, the first sacrifice layer is formed in a region excluding the lower surface of the distal end of the beam portion and other than at least the distal end of the beam portion when seen from a direction perpendicular to a surface of the semiconductor substrate. According to such aspect, the hollow portion can be formed in the region other than the distal end of the beam portion by removing the first sacrifice layer through etching, so that the anchor can be easily formed at the distal end of the beam portion even if the length of the beam portion is made long.

If the semiconductor substrate is a silicon substrate in the manufacturing method of the acoustic sensor according to the present invention, polysilicon or amorphous silicon is desirably used for the first sacrifice layer. A silicon dioxide film or a silicon nitride film is desirably used for the second sacrifice layer.

In accordance with still another aspect of the present invention, there is provided an acoustic sensor including a semiconductor substrate with a back chamber, a vibration thin film arranged on an upper side of the semiconductor substrate, an anchor arranged on an upper surface of the semiconductor substrate, a beam portion being integrally extended from the vibration thin film and having a distal end supported by the anchor, and a back plate fixed to the upper surface of the semiconductor substrate to cover the vibration thin film and the beam portion with a space, for converting an acoustic vibration detected by the vibration thin film to change in electrostatic capacitance between a fixed electrode film arranged on the back plate and the vibration thin film, wherein the anchor includes a lower anchor layer made from a non-conductive material arranged on the upper surface of the semiconductor substrate, an upper anchor layer made from a non-conductive material arranged on the lower surface of the distal end of the beam portion, and a middle anchor layer which is formed from a material different from the upper anchor layer and the lower anchor layer, and which is sandwiched between the upper anchor layer and the lower anchor layer.

According to the acoustic sensor of the present invention, the height of the anchor can be increased since the anchor has a three-layer structure, so that the parasitic capacitance in the anchor can be reduced and lowering in sensitivity of the acoustic sensor by the parasitic capacitance can be alleviated.

If the semiconductor substrate is a silicon substrate in the acoustic sensor according to the present invention, polysilicon or amorphous silicon is desirably used for the first sacrifice layer. A silicon dioxide film or a silicon nitride film is desirably used for the second sacrifice layer.

The means for solving the problems of the invention has a characteristic of appropriately combining the configuring elements described above, and the present invention enables a great number of variations by the combination of the configuring elements.

BRIEF DESCRIPTION OF THE DRAWINGS

Fig. 1A is a cross-sectional view of a conventional acoustic sensor, and Fig. 1B is a plan view in a state a back plate is removed in the conventional acoustic sensor;

Figs. 2A to 2D are cross-sectional views showing one example of a method for manufacturing the conventional acoustic sensor;

Figs. 3A and 3B are schematic views describing a state in which an anchor is formed under the beam portion of the diaphragm in the manufacturing method of Figs. 2A to 2D, and Fig. 3C is a plan view showing a state in which the etching time of the sacrifice layer is extended to reduce the anchor;

Fig. 4A is a schematic view describing a state in which an anchor is formed under the beam portion formed with through-holes in an acoustic sensor disclosed in Japanese Unexamined Patent Publication No. 2009-89097, and Figs. 4B and 4C are a cross-sectional view and a plan view showing the beam portion formed by the relevant method;

Figs. 5A and 5B are a cross-sectional view and a plan view showing the beam portion in which the end is enlarged in the acoustic sensor disclosed in Japanese Unexamined Patent Publication No. 2009-89097;

Fig. 6 is a perspective view showing an acoustic sensor of a comparative example not claimed in a partially exploded manner;

Fig. 7 is a cross-sectional view in the diagonal direction of the acoustic sensor of the example;

Fig. 8 is a plan view showing a specific mode of the acoustic sensor of the example, and also shows one part thereof in an enlarged manner;

Fig. 9A is a plan view of a state in which a plate portion of the acoustic sensor is removed, Fig. 9B is a plan view of a state in which a back plate of the acoustic sensor is removed, Fig. 9C is a plan view of a state in which the back plate and a diaphragm of the acoustic sensor are removed;

Figs. 10A to 10D are schematic cross-sectional views describing the manufacturing process of the acoustic sensor of the example;

Figs. 11A to 11C are schematic cross-sectional views describing the manufacturing process of the acoustic sensor of the example, showing the process following Fig. 10D;

Figs. 12A to 12C are schematic cross-sectional views describing the manufacturing process of the acoustic sensor of the example, showing the process following Fig. 11C;

Fig. 13A is a schematic plan view in the process of Fig. 10A, Fig. 13B is a schematic plan view in the process of Fig. 10B, and Fig. 13C is a schematic cross-sectional view in the process of Fig. 10C;

Fig. 14A is a schematic cross-sectional view in the process of Fig. 10D, Fig. 14B is a schematic cross-sectional view in the process of Fig. 12B, and Fig. 14C is a schematic cross-sectional view in the process of Fig. 12C;

Figs. 15A to 15C are views specifically describing the steps of forming a hollow portion under the beam portion by etching the first sacrifice layer, where Fig. 15C shows a cross-section taken along line Y-Y of Fig. 15B;

Figs. 16A to 16C are views specifically describing the steps of forming an anchor under the beam portion by etching the second sacrifice layer, where Fig. 16C shows a cross-section taken along line Y-Y of Fig. 15B;

Fig. 17A is a cross-sectional view showing one part of an acoustic sensor according to an embodiment of the present invention, Fig. 17B is a plan view showing one part of the acoustic sensor in a state in which the back plate is removed;

Fig. 18A is a cross-sectional view showing an anchor structure of the example,

Fig. 18B is a cross-sectional view showing an anchor structure of the embodiment;

Figs. 19A to 19C are schematic cross-sectional views describing the manufacturing process of an acoustic sensor of an embodiment;

Figs. 20A to 20C are schematic cross-sectional views describing the manufacturing process of the acoustic sensor of the embodiment, showing the process following Fig. 19C;

Fig. 21A is a cross-sectional view showing one portion of the acoustic sensor in the process of Fig. 20A in an enlarged manner, and Fig. 21B is a cross-sectional view taken along line Z-Z of Fig. 21A;

Fig. 22A is a cross-sectional view showing one portion of the acoustic sensor in the process of Fig. 20B in an enlarged manner, and Fig. 22B is a cross-sectional view at a position corresponding to line Z-Z of Fig. 21A in Fig. 22A;

Figs. 23A and 23B are cross-sectional views showing a beam portion shape of when a void between the end of the first sacrifice layer and the middle anchor layer 37b is narrow, and a beam portion shape of when a void between the end of the first sacrifice layer and the middle anchor layer 37b is wide;

Figs. 24A to 24C are cross-sectional views describing another manufacturing process of the acoustic sensor of the embodiment;

Fig. 25 is a schematic view describing a variant of the embodiment; and

Figs. 26A and 26B are cross-sectional views describing the variant.

## DETAILED DESCRIPTION

Hereinafter, an embodiment of the present invention will be described with reference to the accompanied drawings.

(Structure of comparative example)

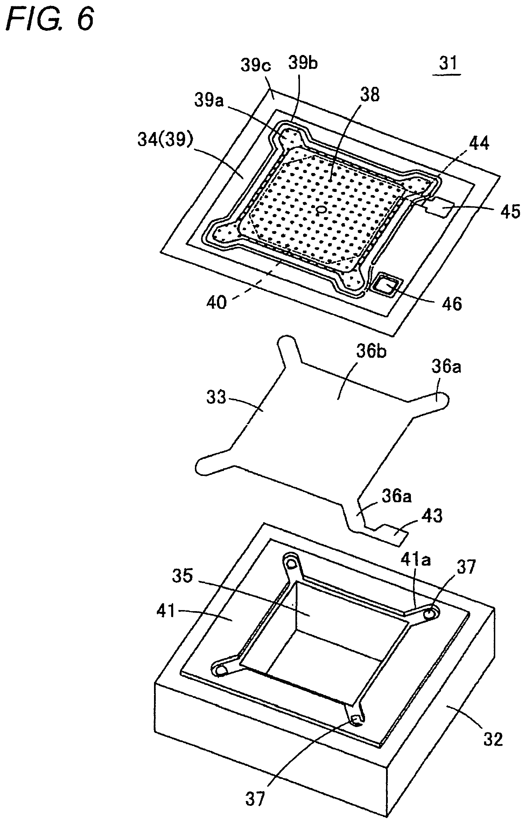

A structure and a manufacturing method of an acoustic sensor 31 according to a comparative example not claimed will be described with reference to Fig. 6 to Fig. 16.

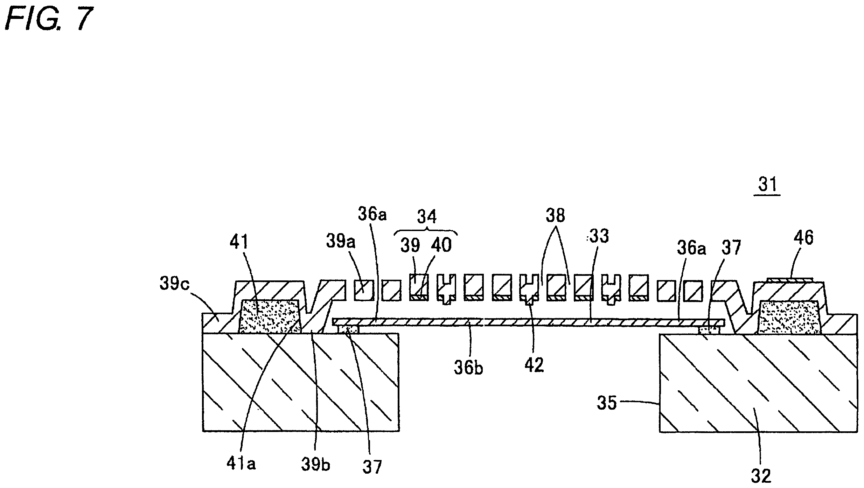

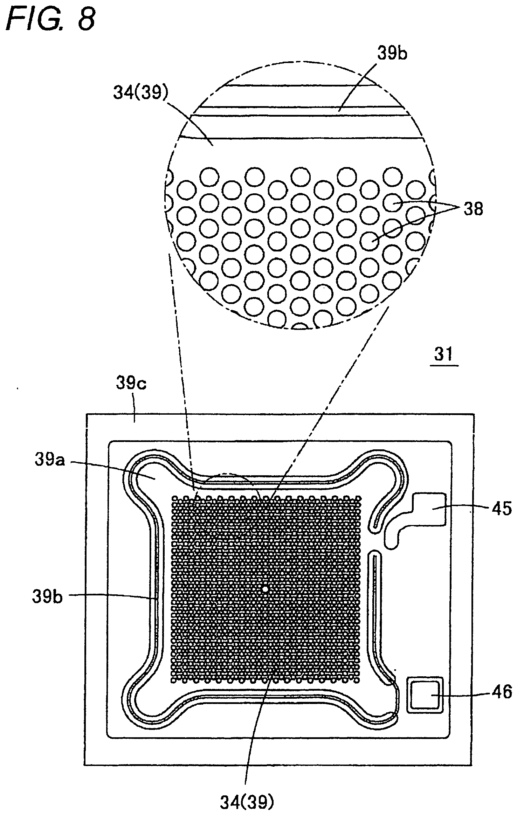

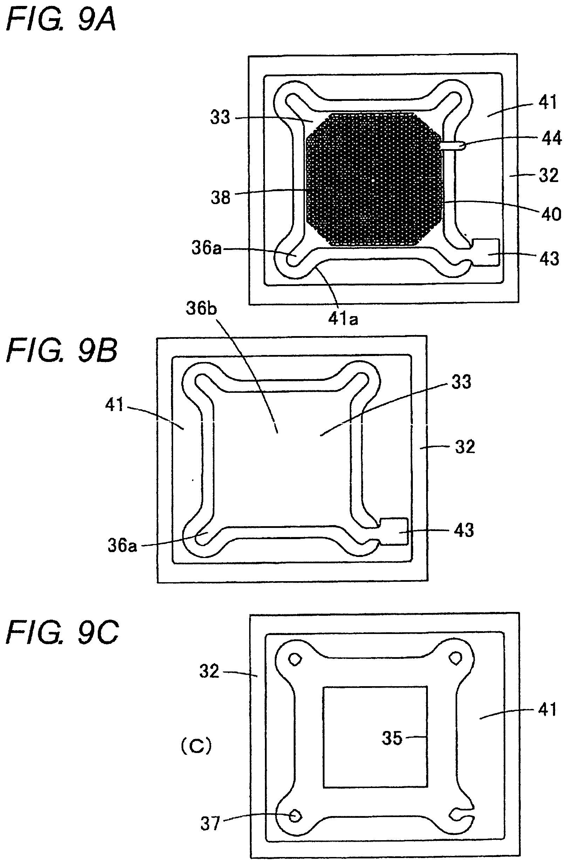

First, the structure of the acoustic sensor 31 of the example will be described. Fig. 6 is a perspective view showing the acoustic sensor 31 in a partially exploded manner. Fig. 7 is a cross-sectional view in the diagonal direction showing the structure of the acoustic sensor 31. Fig. 8 is a plan view showing a more specific and detailed mode of the acoustic sensor 31. Fig. 9A is a plan view of a state in which a plate portion 39 is removed in Fig. 8. Fig. 9B is a plan view of a state in which a back plate 34 is removed in Fig. 8. Fig. 9C is a plan view of a state in which the back plate 34 and a diaphragm 33 are removed in Fig. 8.

The acoustic sensor 31 is a microscopic capacitance type element manufactured using the MEMS technique, where a diaphragm 33 is arranged on the upper surface of a silicon substrate 32 through an anchor 37, and a back plate 34 is arranged thereon through a microscopic gap (cavity), as shown in Fig. 7.

The silicon substrate 32 is made of a monocrystal silicon. As shown in Fig. 6, the silicon substrate 32 is formed to a rectangular shape, and includes a back chamber 35 having a square hole shape that passes from the front surface to the back surface. The inner peripheral surface of the back chamber 35 may be a perpendicular surface or may be inclined to a tapered form. Although not illustrated, the opening at the lower surface of the back chamber 35 is normally blocked by a package, and the like when the acoustic sensor 31 is mounted in the package.

Four anchors 37 for supporting the beam portion 36a of the diaphragm 33 from the lower surface are arranged on the upper surface of the silicon substrate 32, and a base part 41 is formed to surround the back chamber 35 and the anchor 37. In particular, the anchor 37 is positioned within a recessed area 41a formed by cutting the inner peripheral edge of the base part 41 in the diagonal direction of the back chamber 35. The anchor 37 and the base part 41 are made from an insulating material such as $SiO_2$.

The diaphragm 33 is formed by a polysilicon thin film having a film thickness of about 0.7 $\mu$m, and has conductivity. The diaphragm 33 has the beam portion 36a extended outward in the diagonal direction from four corners of a square vibration thin film 36b. An extraction wiring 43 is extended from one of the beam portions 36a.

As shown in Fig. 7, the diaphragm 33 is arranged on the upper surface of the silicon substrate 32 so that the vibration thin film 36b covers the upper surface of the back chamber 35. Each beam portion 36a of the diaphragm 33 is positioned in the recessed area 41a, and the lower surface of the distal end of each beam portion 36a is fixed to the anchor 37. Therefore, the vibration thin film 36b of the diaphragm 33 floats in the air at the upper side of the back chamber 35, and film vibrates in response to the acoustic vibration (air vibration).

The back plate 34 is formed by arranging a fixed electrode film 40 made of polysilicon on the lower surface of the plate portion 39 made of nitride film (SiN). The back plate 34 covers the diaphragm 33 through a microscopic gap of about 3 to 4 $\mu$m in a region facing the diaphragm 33. A beam portion cover region 39a arranged at the corner of the plate portion 39 covers the beam portion 36a. The fixed electrode film 40 faces the vibration thin film 36b or the movable electrode film and configures a capacitor,

The back plate 34 (plate portion 39 and fixed electrode film 40) has a great number of acoustic holes 38 for passing the acoustic vibration perforated so as to pass from the upper surface to the lower surface (the acoustic hole of the plate portion 39 and the acoustic hole of the fixed electrode film 40 are denoted with the same reference number). A small gap is also formed between the lower surface at the outer peripheral part of the vibration thin film 36b and the upper surface of the silicon substrate 32. Therefore, the acoustic vibration that entered the back plate 34 through the acoustic hole 38 vibrates the vibration thin film 36b, and also exits to the back chamber 35 through the gap between the outer peripheral part of the vibration thin film 36b and the silicon substrate 32.

A great number of microscopic stoppers 42 is projected out at the inner surface of the back plate 34 to prevent the diaphragm 33 from being adsorbed or attached (stuck) to the lower surface of the back plate 34.

The base plate 41 formed on the upper surface of the silicon substrate 32 has a height (thickness) substantially equal to the height of the space in the back plate 34. An inner side adhesive region 39b of the plate portion 39 is adhered to the upper surface of the silicon substrate 32 at the inner peripheral part of the base part 41, and an outer side adhesive region 39c of the plate portion 39 is adhered to the upper surface of the silicon substrate 32 at the outer peripheral part of the base part 41, so that the base part 41 is enclosed and sealed between the plate portion 39 and the upper surface of the silicon substrate 32.

As shown in Fig. 9A and Fig. 9B, the extraction wiring 43 is fixed to the upper surface of the base part 41, and an extraction wiring 44 extended from the fixed electrode film 40 is also fixed to the upper surface of the base part 41. As shown in Fig. 8, an opening is formed in the plate portion 39 between the inner side adhesive region 39b and the outer side adhesive region 39c, where a movable side pad 46 (Au film) is formed on the upper surface of the extraction wiring 43 through the relevant opening, through which movable side pad 46 is conducted to the extraction wiring 43 (therefore to the diaphragm 33). The fixed side pad 45 arranged on the upper surface of the plate portion 39 is conducted to the extraction wiring 44 (therefore to the fixed electrode film 40) through a through-hole and the like.

In such acoustic sensor 31, the diaphragm 33, which is a thin film, resonates by the acoustic vibration and film vibrates when the acoustic vibration passes through the acoustic hole 38 and enters the space between the back plate 34 and the diaphragm 33. When the diaphragm 33 vibrates and the gap distance between the diaphragm 33 and the fixed electrode film 40 changes, the electrostatic capacitance between the diaphragm 33 and the fixed electrode film 40 changes. As a result, in such acoustic sensor 31, the acoustic vibration (change in sound pressure) sensed by the diaphragm 33 becomes the change in electrostatic capacitance between the diaphragm 33 and the fixed electrode film 40, and is output as an electrical signal.

Furthermore, in such acoustic sensor 31, the beam portion 36a is extended from four corners of the diaphragm 33, where the distal end of the beam portion 36a is fixed with the anchor 37 and the length of the region not fixed with the anchor 37 in the beam portion 36a is longer. Thus, the diaphragm 33 easily vibrates and the acoustic sensor 31 can have higher sensitivity.

(Manufacturing method of comparative example)

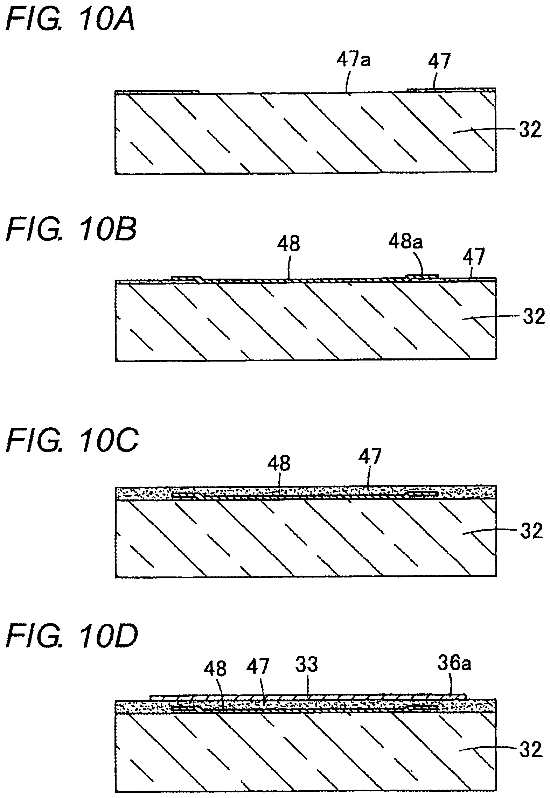

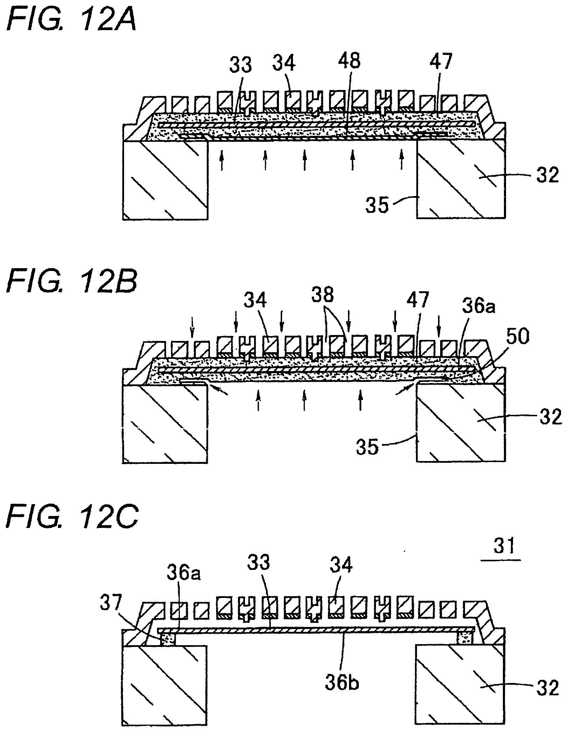

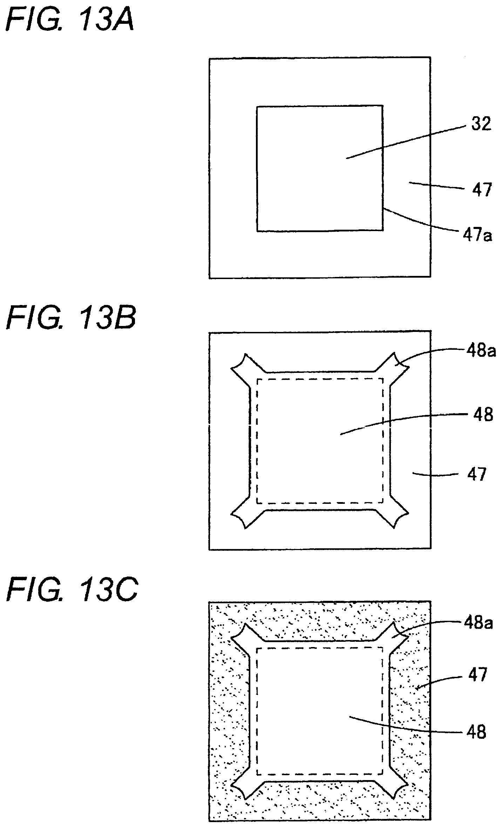

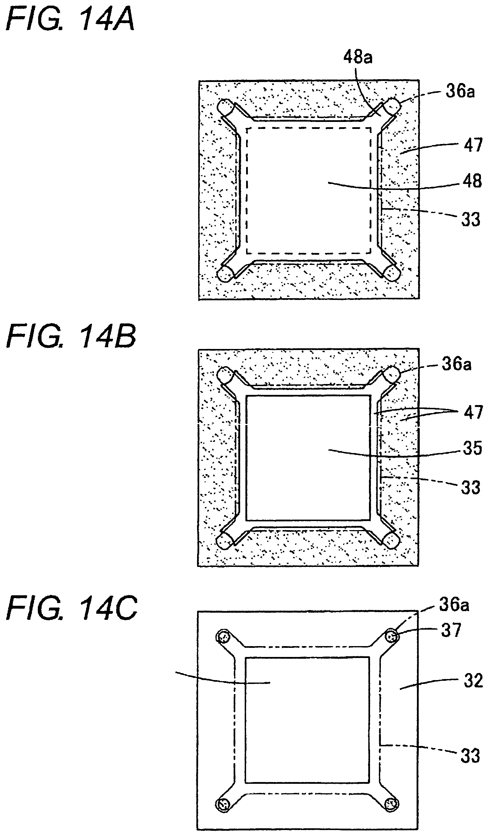

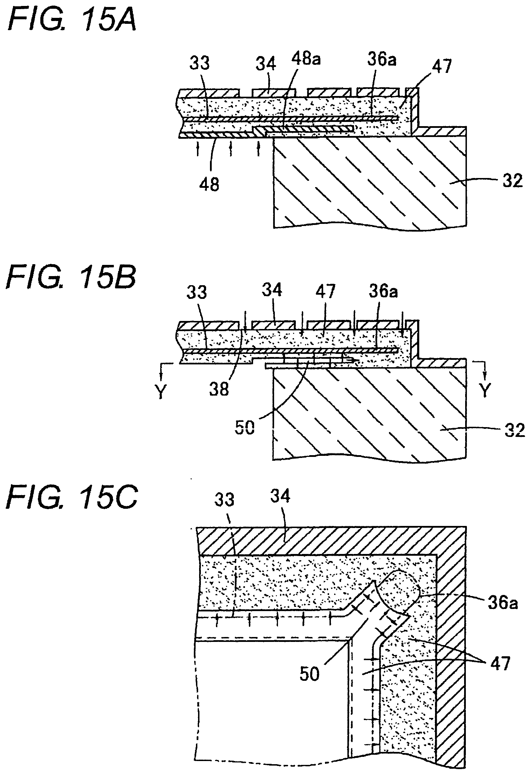

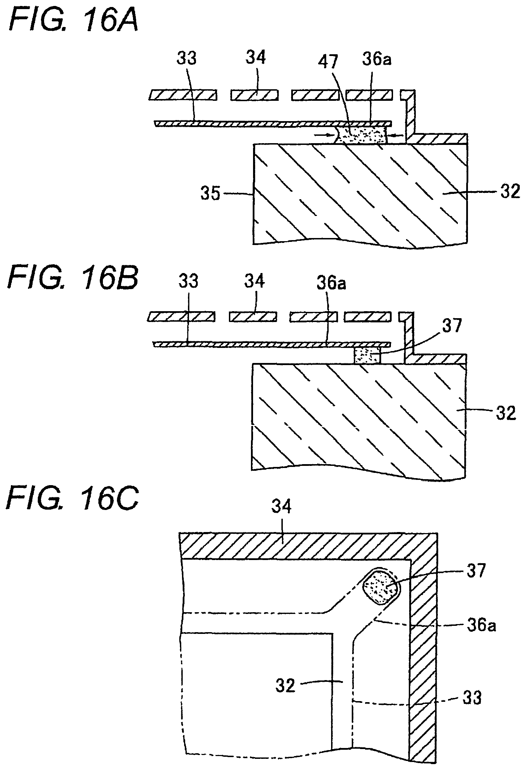

A method of increasing the length of the region not fixed with the anchor 37 in the beam portion 36a in the acoustic sensor 31 will now be described with the manufacturing method using the MEMS technique of the acoustic sensor 31. Figs. 10A to 10D, Figs. 11A to 11C, and Figs. 12A to 12C are schematic cross-sectional views showing an overall flow of the manufacturing process of the acoustic sensor 31. Fig. 13A is a schematic plan view of Fig. 10A. Fig. 13B is a schematic plan view of Fig. 10B. Fig. 13C is a schematic horizontal cross-sectional view of Fig. 10C. Fig. 14A is a schematic horizontal cross-sectional view of Fig. 10D. Fig. 14B is a schematic horizontal cross-sectional view of Fig. 12B. Fig. 14C is a schematic horizontal cross-sectional view of Fig. 12C. Fig. 13C and Figs. 14A to 14C are all cross-sectional views at the same height, and show the horizontal cross-section along the surface of a first sacrifice layer 48 or at a height of the surface of the first sacrifice layer 48. Figs. 15A to 15C, and Figs. 16A to 16C show a state in which the anchor is formed.

First, as shown in Fig. 10A and Fig. 13A, a second sacrifice layer 47 made of silicon dioxide film ($SiO_2$) or silicon nitride film (SiN) is formed through thermal oxidation, CVD method and the like on the surface of the monocrystal silicon substrate 32, and a rectangular opening 47a is formed in the second sacrifice layer 47 to expose the surface of the silicon substrate 32 from the opening 47a. The opening 47a has a dimension equal to or slightly smaller than the opening at the upper surface of the back chamber 35.

Polysilicon or amorphous silicon is deposited on the silicon substrate 32 from above the second sacrifice layer 47 to form a first sacrifice layer 48, and then the first sacrifice layer 48 is etched for patterning as shown in Fig. 10B and Fig. 13B. As a result, the first sacrifice layer 48 covers the entire silicon substrate 32 in the opening 47a and also covers the opening edge of the second sacrifice layer 47, and is also formed with an extended portion 48a on the second sacrifice layer 47 in the diagonal direction. As shown in Fig. 10C and Fig. 13C, the second sacrifice layer 47 made of $SiO_2$ is again deposited over the entire upper surface of the silicon substrate 32 from above to sandwich the first sacrifice layer 48 between the second sacrifice layers 47.

Subsequently, a polysilicon layer is formed on the second sacrifice layer 47, which polysilicon layer is then patterned by etching to form the diaphragm 33 as shown in Fig. 10D and Fig. 14A. In this case, the beam portion 36a of the diaphragm 33 overlaps the extended portion 48a of the first sacrifice layer 48, and the distal end of the beam portion 36a extends longer than the extended portion 48a.

If the extended portion 48a creates a step difference at the surface of the second sacrifice layer 47 thereon to influence the properties and the strength, the diaphragm 33 may be formed after polishing the surface of the second sacrifice layer 47 through chemical mechanical polishing method (CMP method) and the like to make the surface of the second sacrifice layer 47 flat.

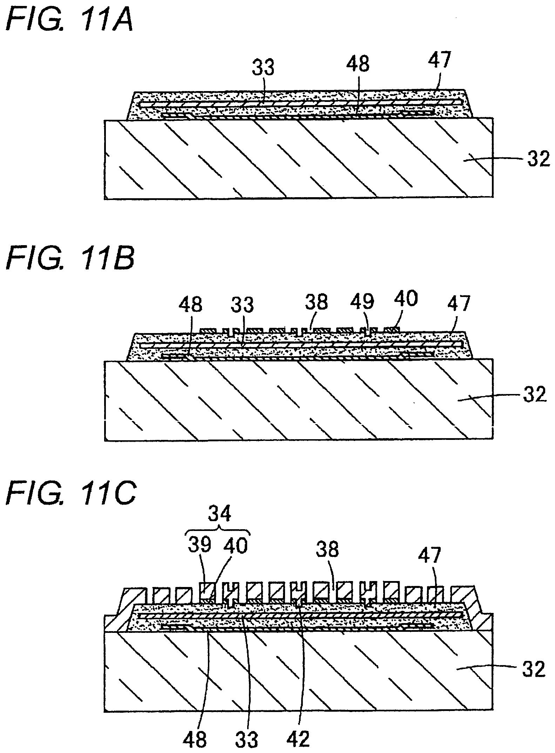

The second sacrifice layer 47 is further deposited on the upper side of the silicon substrate 32 from above the diaphragm 33 to cover the diaphragm 33 with the second sacrifice layer 47, and the second sacrifice layer 47 is etched to form the inner surface shape of the back plate 34 with the second sacrifice layer 47, as shown in Fig. 11A. A polysilicon film is formed on the upper surface of the second sacrifice layer 47, and such polysilicon film is patterned by etching to form the fixed electrode film 40, as shown in Fig. 11B. In this case, the acoustic holes 38 are opened in the fixed electrode film 40, and a hole 49 is dug from the fixed electrode film 40 towards the upper layer part of the second sacrifice layer 47.

Thereafter, the SiN layer is deposited from above the fixed electrode film 40 to form the plate portion 39, as shown in Fig. 11C. In this case, the stopper 42 for preventing fixed attachment is formed by the SiN layer deposited in the hole 49. The acoustic holes 38 are also formed in the plate portion 39 in alignment with the acoustic holes 38 of the fixed electrode film 40 to pass the acoustic holes 38 through the back plate 34.

After the formation of the back plate 34 is completed in such manner, the central part of the silicon substrate 32 is bored from the lower surface side to pass the back chamber 35 in the silicon substrate 32, and expose the first sacrifice layer 48 at the upper surface of the back chamber 35, as shown in Fig. 12A. The so-called DRIE method and the like can be applied for the method of boring the silicon substrate 32.

Then, as shown in Fig. 12B and Fig. 14B, the first sacrifice layer 48 is selectively wet etched with the etchant introduced from the back chamber 35 to remove the first sacrifice layer 48. A hollow portion 50 forms on the upper side of the silicon substrate 32 in the trace after the first sacrifice layer 48 is removed by etching. The etchant used to etch the first sacrifice layer 48 is an etchant to which the second sacrifice layer 47 has etching resistance property.

As shown in Fig. 15A, the first sacrifice layer 48 and the diaphragm 33 do not contact since the second sacrifice layer 47 is formed between the upper surface of the first sacrifice layer 48 and the lower surface of the diaphragm 33, and thus the diaphragm 33 will not be etched when removing the first sacrifice layer 48 by etching. Furthermore, as shown in Fig. 15A, the surface of the silicon substrate 32 is covered with the second sacrifice layer 47 and the first sacrifice layer 48 and the silicon substrate 32 do not contact in the back plate 34, and thus the surface of the silicon substrate 32 is covered with the second sacrifice layer 47 and is not exposed even if the first sacrifice layer 48 is removed by etching, as shown in Fig. 15B. Therefore, the upper surface of the silicon substrate 32 will not be affected or roughened by the etchant when removing the first sacrifice layer 48 by etching, and the properties of the acoustic sensor 31 can be satisfactorily maintained. In this case, the side surface of the back chamber 35 may be covered with a protective film so as not to be etched. For instance, the side surface of the back chamber 35 can be protected by leaving the protective film applied to the side surface when forming the back chamber 35 with the DRIE method while etching the first sacrifice layer. If the diaphragm 33 and the first sacrifice layer 48 are formed from different materials so that the diaphragm 33 is not affected by the etchant when etching the first sacrifice layer 48 and the surface of the silicon substrate 32 is also not affected or roughened by the etchant, the first sacrifice layer 48 may be formed over the entire thickness between the diaphragm 33 and the surface of the silicon substrate 32 in a region other than the distal end of the beam portion 36a.

Thereafter, the etchant such as hydrofluoric acid is introduced from the acoustic hole 38 of the back plate 34, the back chamber 35 of the silicon substrate 32, and the like to selectively wet etch the second sacrifice layer 47, and the second sacrifice layer 47 is removed leaving only the second sacrifice layer 47 under the beam portion 36a for the anchor 37 as shown in Fig. 12C and Fig. 14C. As a result, the diaphragm 33 floats from the upper surface of the silicon substrate 32 by the anchor 37 and supported above the back chamber 35 in such manner that it can be vibrated, whereby the air gap forms between the fixed electrode film 40 and the diaphragm 33.

As shown in Figs. 15B and 15C, the hollow portion 50 is formed in advance in the region excluding the distal end under the beam portion 36a, and the etchant is infiltrated into the hollow portion 50 in the etching removing step of the second sacrifice layer 47. As shown with an arrow in the figures, the second sacrifice layer 47 is etched from the hollow portion 50, so that the second sacrifice layer 47 at the lower surface of the distal end of the beam portion 36a is rapidly removed by etching and the second sacrifice layer 47 at the lower surface of the distal end of the beam portion 36a ultimately remains, as shown in Fig. 16A. As a result, the anchor 37 can be formed at the lower surface of the distal end of the beam portion 36a as shown in Figs. 16B and 16C no matter how long the length of the beam portion 36a is made. The position and the size of the anchor 37 can be freely adjusted by adjusting the length of the extended portion 48a.

In the manufacturing method described above, the first sacrifice layer 48 is formed (see Fig. 10B) so that the edge and the extended portion 48a of the first sacrifice layer 48 overlaps on the second sacrifice layer 47, but an opening 47a of the second sacrifice layer 47 may be opened in accordance with the shape of the first sacrifice layer 48, and the first sacrifice layer 48 may be formed to the same thickness so as not to overlap the second sacrifice layer 47 formed the first time. The upper surface of the second sacrifice layer 47 formed the second time thus can be flattened, whereby the diaphragm 33 can be formed flatter.

In the manufacturing method described above, the wet etching by the etchant is used, but the wet etching is not the sole case, and dry etching by semiconductor gas and the like can be selected in view of the etching resistance and the etching characteristics.

(Structure of embodiment)

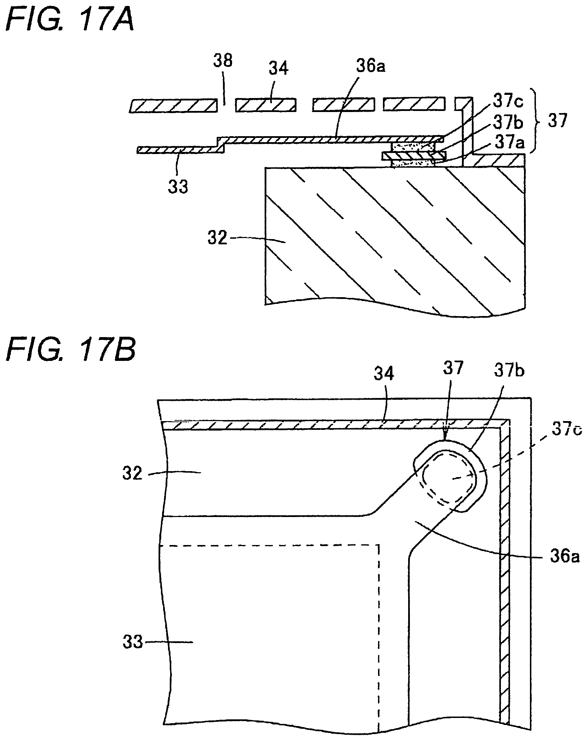

A structure of an acoustic sensor according to an embodiment of the present invention will now be described. Fig. 17A is a cross-sectional view showing a beam portion structure of the diaphragm 33 according to the embodiment. Fig. 17B is a plan view of the beam portion in a state in which the back plate is removed.

The anchor 37 has a two-layer structure of the same material (second sacrifice layer 47) in the comparative example, but the anchor 37 has a multi-layered structure in the embodiment. In other words, as shown in Fig. 17, the anchor 37 has a three-layer structure of a lower anchor layer 37a formed from the second sacrifice layer 47, a middle anchor layer 37b formed from the first sacrifice layer 48, and an upper anchor layer 37c formed from the second sacrifice layer 47. Therefore, if the deposition thickness of the second sacrifice layer 47 and the first sacrifice layer 48 is the same as the comparative example, the anchor 37 of the embodiment becomes higher than the anchor 37 of the comparative example by the thickness of the middle anchor layer 37b.

In the anchor 37 of the embodiment as well, it is designed so that the middle anchor layer 37b has an area greater than the lower anchor layer 37a and the upper anchor layer 37c. This is to prevent the lower anchor layer 37a and the upper anchor layer 37c from having an area greater than the middle anchor layer 37b due to variation when etching the second sacrifice layer 47, and the anchor 37 from becoming an unstable shape.

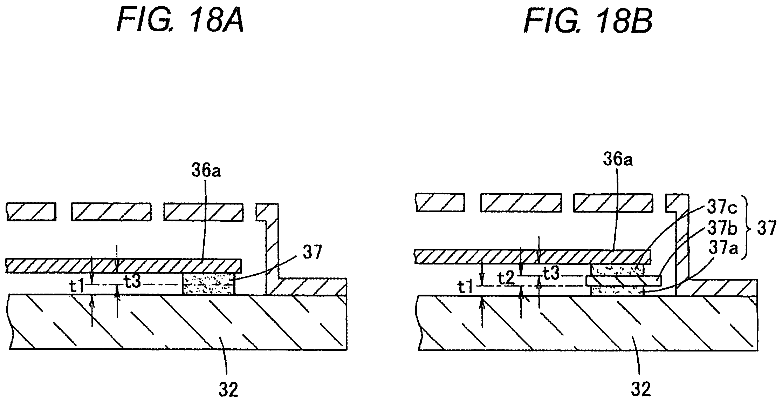

Figs. 18A and 18B are views describing the characteristics of the embodiment compared to the comparative example. Fig. 18A shows the anchor 37 of the two-layer structure in the comparative example. Fig. 18B shows the anchor 37 of the three-layer structure in the embodiment. In Figs. 18A and 18B, the thickness t1 indicates the deposition thickness of the second sacrifice layer 47 formed the first time, the thickness t3 indicates the deposition thickness of the second sacrifice layer 47 formed the second time, and the thickness t2 indicates the deposition thickness of the first sacrifice layer 48.

Assuming the relative permittivity of the second sacrifice layer 47 is $\varepsilon 1$, the relative permittivity of the first sacrifice layer 48 is $\varepsilon 2$, the dielectric constant in vacuum is $\varepsilon 0$, and the area of the anchor 37 is S, the parasitic capacitance C1 in the anchor 37 of the comparative example of Fig. 18A can be expressed with equation 1.

[Equation 1]

$$C1 = \varepsilon 0 \frac{S}{\dfrac{t1}{\varepsilon 1} + \dfrac{t3}{\varepsilon 1}}$$

The parasitic capacitance C2 in the anchor 37 of the embodiment of Fig. 18B can be expressed with equation 2.

[Equation 2]

$$C2 = \varepsilon 0 \frac{S}{\dfrac{t1}{\varepsilon 1} + \dfrac{t2}{\varepsilon 2} + \dfrac{t3}{\varepsilon 1}}$$

The denominator of equation 2 is greater than the denominator of equation 1, and thus C1 > C2. In other words, according to the anchor structure of the embodiment, the parasitic capacitance of the anchor 37 can be reduced and the lowering in sensitivity of the acoustic sensor due to the parasitic capacitance can be alleviated.

According to the embodiment, the height of the anchor 37 is higher by the thickness t2 of the middle anchor layer 37b, and hence the distance between the beam portion 36a and the surface of the silicon substrate 32 can be made greater than the comparative example and the risk of the diaphragm 33 fixedly attaching to the silicon substrate 32 by moisture, static electricity, and the like can be alleviated. Furthermore, microscopic dust is less likely to get stuck between the beam portion 36a and the silicon substrate 32.

(Manufacturing method of embodiment)

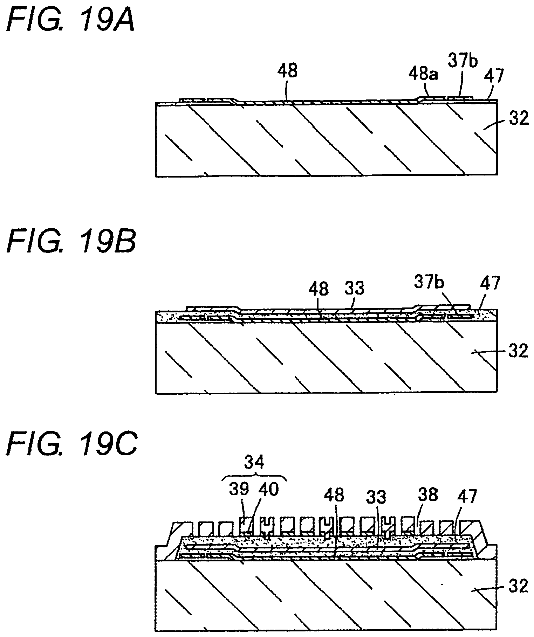

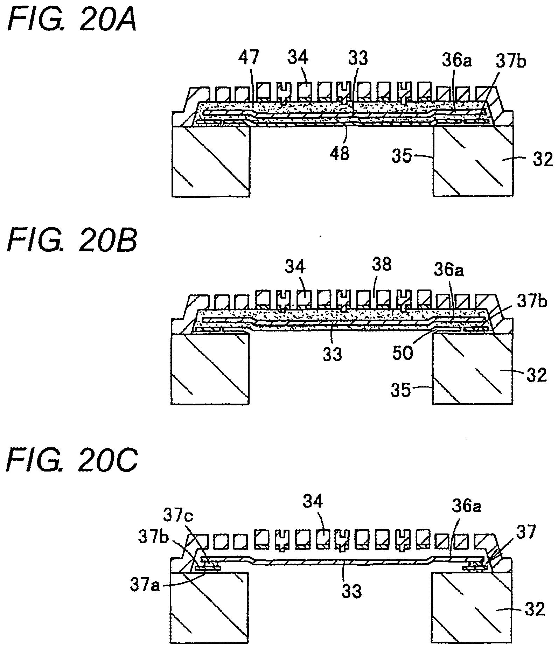

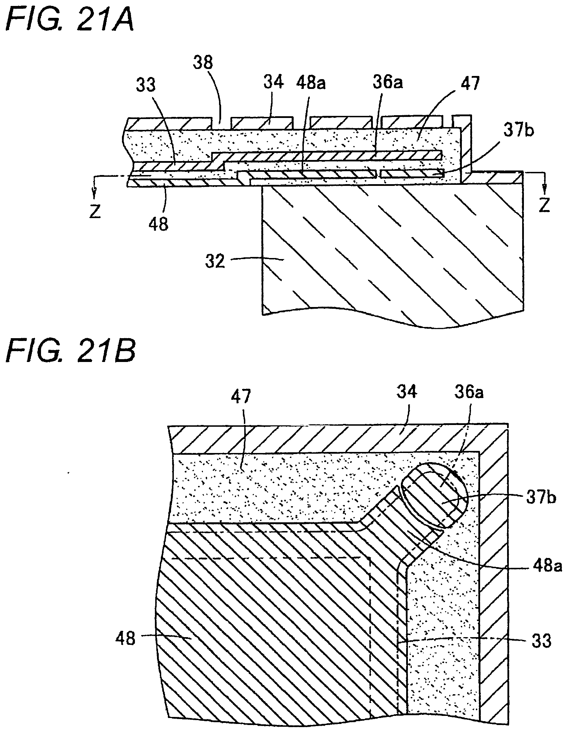

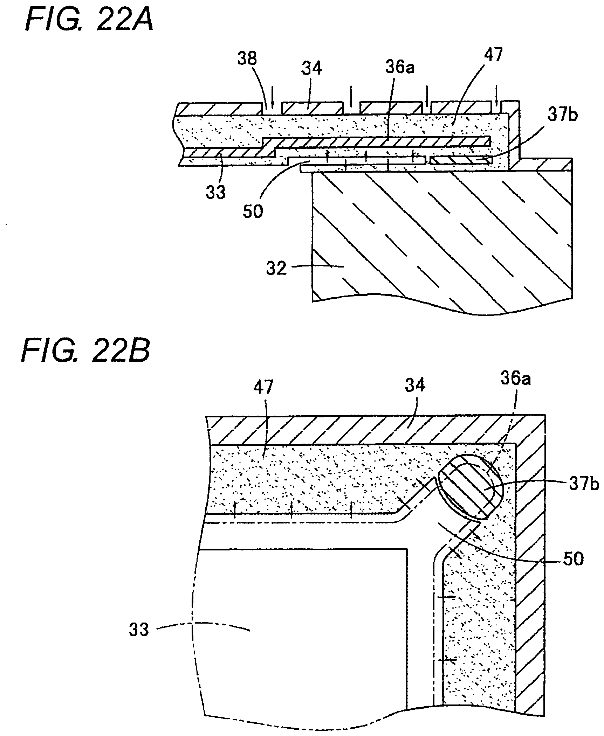

The manufacturing process of an acoustic sensor of the embodiment will now be described with reference to Figs. 19 to 22. Figs. 19A to 19C and Figs. 20A to 20C are schematic cross-sectional views showing an overall flow of the manufacturing process of the acoustic sensor of the embodiment. Fig. 21A is a schematic cross-sectional view showing one portion of Fig. 20A in an enlarged manner, and Fig. 21B is a cross-sectional view taken along line Z-Z of Fig. 21A. Fig. 22A is a schematic cross-sectional view showing one portion of Fig. 20B in an enlarged manner, and Fig. 22B is a horizontal cross-sectional view of Fig. 22A at a height corresponding to Fig. 21B.

In the case of the embodiment, a polysilicon layer is left to form a middle anchor layer 37b separate from the extended portion 48a (see Fig. 21B) at the tip of the extended portion 48a, as shown in Fig. 9A, when arranging the first sacrifice layer 48 made of polysilicon or amorphous silicon on the silicon substrate 32 formed with the second sacrifice layer 47 ($SiO_2$ or SiN).

As shown in Fig. 19B, the second sacrifice layer 47 is then deposited on the silicon substrate 32 so as to cover the first sacrifice layer 48 and the middle anchor layer 37b, and then the diaphragm 33 is formed by the polysilicon on the second sacrifice layer 47. The second sacrifice layer 47 is patterned to the inner surface shape of the back plate 34, and then the back plate 34 is formed thereon as shown in Fig. 19C.

Thereafter, as shown in Fig. 20A, the silicon substrate 32 is dry etched through the DRIE method and the like to vertically form the back chamber 35, and then the first sacrifice layer 48 is selectively removed by etching as shown in Fig. 20B. Figs. 21A and 21B show the state before the first sacrifice layer 48 is removed by etching, where the middle anchor layer 37b is separated from the first sacrifice layer 48 by the second sacrifice layer 47 so that the middle anchor layer 37b remains without being etched even if the first sacrifice layer 48 is removed by etching as shown in Figs. 22A and 22B.

When removing the second sacrifice layer 47 by etching with the etchant infiltrated from the acoustic hole 38 and the hollow portion 50, the second sacrifice layer 47 remains at the distal end of the beam portion 36a as shown in Fig. 20C, so that the anchor 37 in which the lower anchor layer 37a formed by the second sacrifice layer 47, the middle anchor layer 37b made of polysilicon and the upper anchor layer 37c formed by the second sacrifice layer 47 are stacked is formed at the distal end of the beam portion 36a.

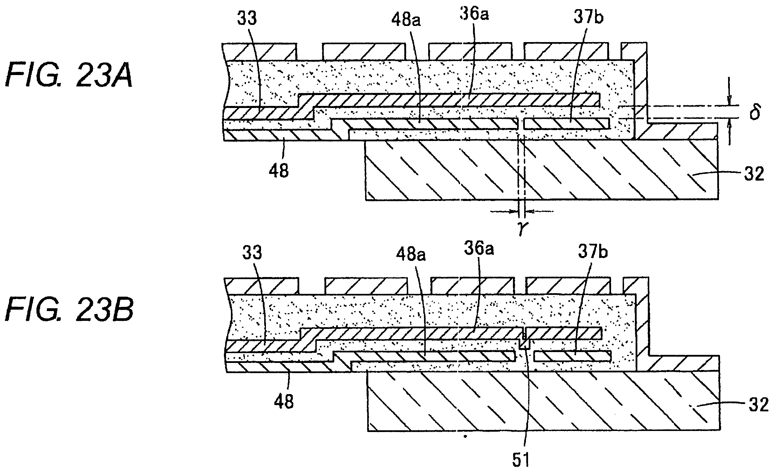

The interval $\delta$ between the extended portion 48a and the middle anchor layer 37b and the beam portion 36a is about 1 $\mu$m to a few $\mu$m, and hence the void $\gamma$ between the extended portion 48a and the middle anchor layer 37b is also preferably smaller than or equal to a few $\mu$m (see Fig. 23A). In other words, if the void $\gamma$ between the extended portion 48a and the middle anchor layer 37b is wide, a linear depression forms at the surface of the second sacrifice layer 47 when the second sacrifice layer 47 is formed on the first sacrifice layer 48 as shown in Fig. 23B thereby forming a linear bump 51 at the beam portion 36a. When such bump 51 forms, stress concentrates at the portion of the bump 51 at the time of vibration of the diaphragm 33, which leads to lowering of the mechanical strength. Therefore, the void $\gamma$ between the extended portion 48a and the middle anchor layer 37b is desirably smaller than or equal to 2 $\mu$m.

In the acoustic sensor of the embodiment, a bump does not form between the distal end of the beam portion 36a (beam portion 36a on the middle anchor layer 37b) and the region other than the distal end of the beam portion 36a (beam portion 36a on the extended portion 48a) even if polishing is not carried out through the CMP method or the like since the polysilicon layer (extended portion 48a and middle anchor layer 37b) is formed over the entire length on the lower side of the beam portion 36a, and hence the beam portion 36a can be formed flat over the entire length. Therefore, stress is less likely to concentrate at the beam portion 36a, whereby the mechanical strength of the beam portion 36a enhances and resistance to drop impact and the like also enhances. In the embodiment, the bump portion may form on the vibration thin film 36b as shown in Fig. 17A if polishing is not carried out through the CMP method or the like, but stress is less likely to concentrate since the bump is not formed on the beam portion 36a, whereby the mechanical strength enhances and resistance to drop impact and the like also enhances.

(Variant)

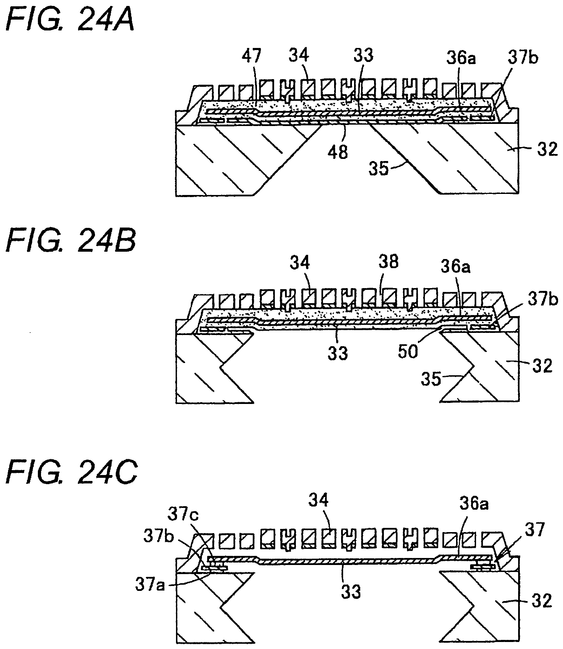

Figs. 24A to 24C are views describing a variant of the acoustic sensor. In this variant, the silicon substrate 32 is wet etched with a TMAH solution or the like to open the back chamber 35. When the silicon substrate 32 is etched from the rear surface with the TMAH solution or the like, the tapered back chamber 35 is first formed as shown in Fig. 24A, and then the back chamber 35 is formed to a shape in which the central part of the side surface is depressed, as shown in Fig. 24B, if the etching is continued. The acoustic sensor as shown in Fig. 24C is thereby formed, where the volume of the back chamber 35 can be increased to enhance the sensitivity of the acoustic sensor.

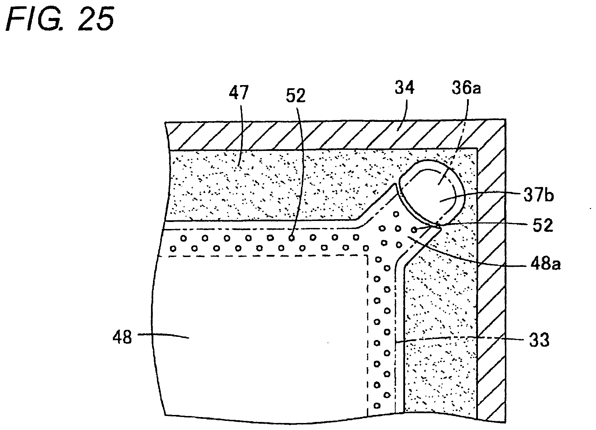

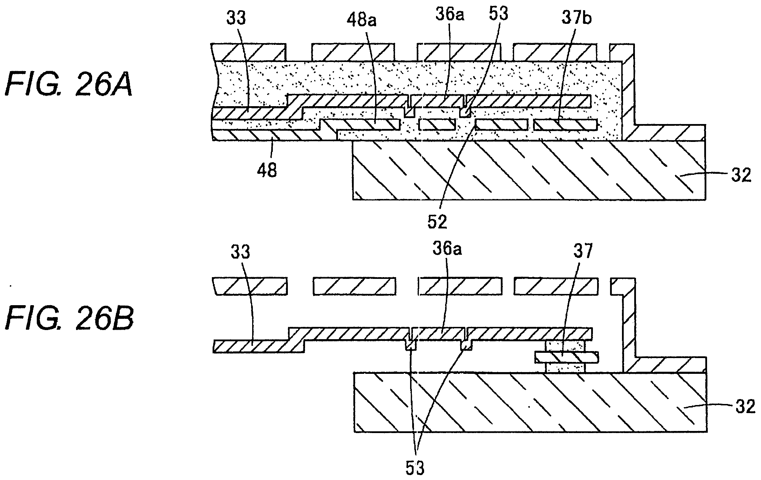

Fig. 25 and Figs. 26A and 26B show another variant. In this variant, a great number of holes 52 are opened at the edge and the extended portion 48a of the first sacrifice layer 48, as shown in Fig. 25 and Fig. 26A. If the hole 52 is opened at the edge and the extended portion 48a of the first sacrifice layer 48, the second sacrifice layer 47 deposited thereon depresses roundly, and hence the projection stopper 53 as shown in Fig. 26B is formed at the lower surface of the diaphragm 33 (edge and the beam portion 36a of the vibration thin film 36b) formed thereon. When the stopper 53 is brought into contact with the upper surface of the silicon substrate 32, the diaphragm 33 can be prevented from becoming too close to the silicon substrate 32 and the diaphragm 33 can be prevented from being fixedly attached to the silicon substrate 32.

The case of the embodiment is shown in Figs. 24 to 26.

**Claims**

1. A manufacturing method of an acoustic sensor (31) including
   a semiconductor substrate (32) with a back chamber (35),
   a vibration thin film (36b) arranged on an upper side of the semiconductor substrate (32),
   an anchor (37) arranged on an upper surface of the semiconductor substrate (32),
   a beam portion (36a) being integrally extended from the vibration thin film (36b) and having a distal end supported by the anchor (37), and
   a back plate (34) fixed to the upper surface of the semiconductor substrate (32) to cover the vibration thin film (36b) and the beam portion (36a) with a space,
   an acoustic vibration detected by the vibration thin film (36b) being converted to change in electrostatic capacitance between a fixed electrode film (40) arranged on the back plate (34) and the vibration thin film (36b), the manufacturing method comprising the steps of:

forming a first sacrifice layer (48) and a second sacrifice layer (47) between a surface of the semiconductor substrate (32) and a lower surface of the vibration thin film (36b) and the beam portion (36a), covering an upper surface of the vibration thin film (36b) and the beam portion (36a) with the second sacrifice layer (47) and arranging the vibration thin film (36b) and the beam portion (36a) in a sacrifice layer including the first sacrifice layer (48) and the second sacrifice layer (47);

forming the back plate (34) on the second sacrifice layer (47);

forming the back chamber (35) in the semiconductor substrate (32);

removing the first sacrifice layer (48) by etching; and

removing one part of the second sacrifice layer (47) by etching after removing the first sacrifice layer (48) by etching and forming the anchor (37) between said lower surface of the distal end of the beam portion (36a) and the surface of the semiconductor substrate (32) from the remaining second sacrifice layer (47), wherein the first sacrifice layer (48) and the second sacrifice layer (47) are formed between the surface of the semiconductor substrate (32) and the lower surface of the vibration thin film (36b) and the beam portion (36a) to cover at least one of the lower surface of the beam portion (36a) or a region facing the beam portion (36a) in the semiconductor substrate (32) with the second sacrifice layer (47) and an anchor layer (37b) is formed between the distal end of the beam portion (36a) and the semiconductor substrate (32) separate from the first sacrifice layer (48) with the same material as the first sacrifice layer (48); and

one part of the second sacrifice layer (47) is removed by etching after removing the first sacrifice layer (48) by etching and the anchor (37) is formed between the lower surface of the distal end of the beam portion (36a) and the surface of the semiconductor substrate (32) from the remaining second sacrifice layer (47) and the anchor layer (37b).

2. The manufacturing method of the acoustic sensor (31) according to claim 1, **characterized in that** the first sacrifice layer (48) is formed in a region excluding the lower surface of the distal end of the beam portion (36a) and other than at least the distal end of the beam portion (36a) when seen from a direction perpendicular to the surface of the semiconductor substrate (32).

3. The manufacturing method of the acoustic sensor (31) according to claim 1, **characterized in that**
the semiconductor substrate (32) is a silicon substrate; and
the first sacrifice layer (48) is polysilicon or amorphous silicon.

4. The manufacturing method of the acoustic sensor (31) according to claim 1, **characterized in that**
the semiconductor substrate (32) is a silicon substrate; and
the second sacrifice layer (47) is silicon dioxide film or silicon nitride film.

5. An acoustic sensor (31) comprising
a semiconductor substrate (32) with a back chamber (35),
a vibration thin film (36b) arranged on an upper side of the semiconductor substrate (32),
an anchor (37) arranged on an upper surface of the semiconductor substrate (32),
a beam portion (36a) being integrally extended from the vibration thin film (36b) and having a distal end supported by the anchor (37), and
a back plate (34) fixed to the upper surface of the semiconductor substrate (32) to cover the vibration thin film (36b) and the beam portion (36a) with a space,
an acoustic vibration detected by the vibration thin film (36b) being converted to change in electrostatic capacitance between a fixed electrode film (40) arranged on the back plate (34) and the vibration thin film (36b), wherein
the anchor (37) includes a lower anchor layer (37a) made from a non-conductive material arranged on the upper surface of the semiconductor substrate (32), an upper anchor layer (37c) made from a non-conductive material arranged on the lower surface of the distal end of the beam portion (36a), and a middle anchor layer (37b) which is formed from a material different from the upper anchor layer (37c) and the lower anchor layer (37a), and which is sandwiched between the upper anchor layer (37c) and the lower anchor layer (37a).

6. The acoustic sensor (31) according to claim 5, **characterized in that**
the semiconductor substrate (32) is a silicon substrate; and
the middle anchor layer (37b) is polysilicon or amorphous silicon.

**7.** The acoustic sensor (31) according to claim 5, **characterized in that**
the semiconductor substrate (32) is a silicon substrate; and
the lower anchor layer (37a) and the upper anchor layer (37c) are silicon dioxide film or silicon nitride film.


**Patentansprüche**

**1.** Herstellungsverfahren für einen Akustiksensor (31), enthaltend
ein Halbleitersubstrat (32) mit einer Rückkammer (35),
einen Vibrationsdünnfilm (36b), der auf einer Oberseite des Halbleitersubstrats (32) angeordnet ist,
eine Verankerung (37), die auf einer oberen Oberfläche des Halbleitersubstrats (32) angeordnet ist,
einen Trägerabschnitt (36a), der sich als integraler Bestandteil vom Vibrationsdünnfilm (36b) erstreckt und ein
Distalende aufweist, das von der Verankerung (37) gehalten wird, und
eine Rückplatte (34), die an der oberen Oberfläche des Halbleitersubstrats (32) befestigt ist, um den Vibrationsdünnfilm (36b) und den Trägerabschnitt (36a) mit Abstand abzudecken,
wobei eine akustische Vibration, die vom Vibrationsdünnfilm (36b) erfasst wird, umgewandelt wird, um eine elektrostatische Kapazität zwischen einem befestigten Elektrodenfilm (40), der auf der Rückplatte (34) angeordnet ist,
und dem Vibrationsdünnfilm (36b) zu ändern,
wobei das Herstellungsverfahren folgende Schritte umfasst:

Bilden einer ersten Opferschicht (48) und einer zweiten Opferschicht (47) zwischen einer Oberfläche des Halbleitersubstrats (32) und einer unteren Oberfläche des Vibrationsdünnfilms (36b) und dem Trägerabschnitt (36a),
Abdecken einer oberen Oberfläche des Vibrationsdünnfilms (36b) und des Trägerabschnitts (36a) mit der zweiten Opferschicht (47) und Anordnen des Vibrationsdünnfilms (36b) und des Trägerabschnitts (36a) in einer
Opferschicht, die die erste Opferschicht (48) und die zweite Opferschicht (47) enthält;
Bilden der Rückplatte (34) auf der zweiten Opferschicht (47);
Bilden der Rückkammer (35) im Halbleitersubstrat (32);
Entfernen der ersten Opferschicht (48) durch Ätzen; und
Entfernen eines Teils der zweiten Opferschicht (47) durch Ätzen nach Entfernen der ersten Opferschicht (48)
durch Ätzen und Bilden der Verankerung (37) zwischen der unteren Oberfläche des Distalendes des Trägerabschnitts (36a) und der Oberfläche des Halbleitersubstrats (32) aus der verbleibenden zweiten Opferschicht
(47), wobei die erste Opferschicht (48) und die zweite Opferschicht (47) zwischen der Oberfläche des Halbleitersubstrats (32) und der unteren Oberfläche des Vibrationsdünnfilms (36b) und des Trägerabschnitts (36a) so
gebildet sind, dass mindestens eine der unteren Oberfläche des Trägerabschnitts (36a) oder einer Region, die
dem Trägerabschnitt (36a) im Halbleitersubstrat (32) zugewandt ist, mit der zweiten Opferschicht (47) abgedeckt
ist und eine Verankerungsschicht (37b) zwischen dem Distalende des Trägerabschnitts (36a) und dem Halbleitersubstrat (32), getrennt von der ersten Opferschicht (48), aus demselben Material wie die erste Opferschicht
(48) gebildet wird; und
wobei ein Teil der zweiten Opferschicht (47) durch Ätzen nach Entfernen der ersten Opferschicht (48) durch
Ätzen entfernt wird und die Verankerung (37) zwischen der unteren Oberfläche des Distalendes des Trägerabschnitts (36a) und der Oberfläche des Halbleitersubstrats (32) aus der verbleibenden zweiten Opferschicht (47)
und der Verankerungsschicht (37b) gebildet wird.

**2.** Herstellungsverfahren für den Akustiksensor (31) nach Anspruch 1, **dadurch gekennzeichnet, dass** die erste
Opferschicht (48) in einer Region gebildet ist, die die untere Oberfläche des Distalendes des Trägerabschnitts (36a)
ausschließt und sich von wenigstens dem Distalende des Trägerabschnitts (36a) unterscheidet, bei Betrachtung
aus einer Richtung senkrecht zur Oberfläche des Halbleitersubstrats (32).

**3.** Herstellungsverfahren für den Akustiksensor (31) nach Anspruch 1, **dadurch gekennzeichnet, dass**
das Halbleitersubstrat (32) ein Siliziumsubstrat ist; und
die erste Opferschicht (48) Polysilizium oder amorphes Silizium ist.

**4.** Herstellungsverfahren für den Akustiksensor (31) nach Anspruch 1, **dadurch gekennzeichnet, dass**
das Halbleitersubstrat (32) ein Siliziumsubstrat ist; und
die zweite Opferschicht (47) ein Siliziumdioxidfilm oder ein Siliziumnitridfilm ist.

**5.** Akustiksensor (31), umfassend
ein Halbleitersubstrat (32) mit einer Rückkammer (35),

einen Vibrationsdünnfilm (36b), der auf einer Oberseite des Halbleitersubstrat (32) angeordnet ist,

eine Verankerung (37), die auf einer oberen Oberfläche des Halbleitersubstrats (32) angeordnet ist,

einen Trägerabschnitt (36a), der sich als integraler Bestandteil von dem Vibrationsdünnfilm (36b) erstreckt und ein Distalende aufweist, das von der Verankerung (37) gehalten wird, und

eine Rückplatte (34), die an der oberen Oberfläche des Halbleitersubstrats (32) befestigt ist, um den Vibrationsdünnfilm (36b) und den Trägerabschnitt (36a) mit Abstand abzudecken,

wobei eine akustische Vibration, die vom Vibrationsdünnfilm (36b) erfasst wird, umgewandelt wird, um eine elektrostatische Kapazität zwischen einem befestigten Elektrodenfilm (40), der auf der Rückplatte (34) angeordnet ist, und dem Vibrationsdünnfilm (36b) zu ändern, wobei

die Verankerung (37) eine untere Verankerungsschicht (37a) aus einem nicht leitendem Material, die auf der oberen Oberfläche des Halbleitersubstrats (32) angeordnet ist, eine obere Verankerungsschicht (37c) aus nicht leitendem Material, die auf der unteren Oberfläche des Distalendes des Trägerabschnitts (36a) angeordnet ist, und eine mittlere Verankerungsschicht (37b) enthält, die aus einem anderen Material als die obere Verankerungsschicht (37c) und die untere Verankerungsschicht (37a) gebildet ist und die zwischen der oberen Verankerungsschicht (37c) und der unteren Verankerungsschicht (37a) liegt.

**6.** Akustiksensor (31) nach Anspruch 5, **dadurch gekennzeichnet, dass**
das Halbleitersubstrat (32) ein Siliziumsubstrat ist; und
die mittlere Verankerungsschicht (37b) Polysilizium oder amorphes Silizium ist.

**7.** Akustiksensor (31) nach Anspruch 5, **dadurch gekennzeichnet, dass**
das Halbleitersubstrat (32) ein Siliziumsubstrat ist; und
die untere Verankerungsschicht (37a) und die obere Verankerungsschicht (37c) ein Siliziumdioxidfilm oder ein Siliziumnitridfilm sind.

## Revendications

**1.** Procédé de fabrication d'un capteur acoustique (31) comprenant

un substrat semi-conducteur (32) avec une chambre arrière (35),

un film mince de vibration (36b) agencé sur un côté supérieur du substrat semi-conducteur (32),

un dispositif d'ancrage (37) agencé sur une surface supérieure du substrat semi-conducteur (32),

une partie formant poutre (36a) s'étendant d'un seul tenant à partir du film mince de vibration (36b) et ayant une extrémité distale supportée par le dispositif d'ancrage (37), et

une plaque arrière (34) fixée à la surface supérieure du substrat semi-conducteur (32) pour recouvrir le film mince de vibration (36b) et la partie formant poutre (36a) avec un espace,

une vibration acoustique détectée par le film mince de vibration (36b) étant convertie en un changement de capacitance électrostatique entre un film d'électrode fixe (40) agencé sur la plaque arrière (34) et le film mince de vibration (36b),

le procédé de fabrication comprenant les étapes :

de formation d'une première couche sacrificielle (48) et d'une deuxième couche sacrificielle (47) entre une surface du substrat semi-conducteur (32) et une surface inférieure du film mince de vibration (36b) et de la partie formant poutre (36a),

de recouvrement d'une surface supérieure du film mince de vibration (36b) et de la partie formant poutre (36a) avec la deuxième couche sacrificielle (47) et d'agencement du film mince de vibration (36b) et de la partie formant poutre (36a) dans une couche sacrificielle comprenant la première couche sacrificielle (48) et la deuxième couche sacrificielle (47) ;

de formation de la plaque arrière (34) sur la deuxième couche sacrificielle (47) ;

de formation de la chambre arrière (35) dans le substrat semi-conducteur (32) ;

de retrait de la première couche sacrificielle (48) par gravure ; et

de retrait d'une partie de la deuxième couche sacrificielle (47) par gravure après avoir retiré la première couche sacrificielle (48) par gravure et de formation du dispositif d'ancrage (37) entre ladite surface inférieure de l'extrémité distale de la partie formant poutre (36a) et la surface du substrat semi-conducteur (32) à partir de la deuxième couche sacrificielle (47) restante, dans lequel la première couche sacrificielle (48) et la deuxième couche sacrificielle (47) sont formées entre la surface du substrat semi-conducteur (32) et la surface inférieure du film mince de vibration (36b) et de la partie formant poutre (36a) pour recouvrir au moins l'une de la surface inférieure de la partie formant poutre (36a) ou d'une région faisant face à la partie formant poutre (36a) dans

13

le substrat semi-conducteur (32) avec la deuxième couche sacrificielle (47) et une couche d'ancrage (37b) est formée entre l'extrémité distale de la partie formant poutre (36a) et le substrat semi-conducteur (32) séparée de la première couche sacrificielle (48) avec le même matériau que la première couche sacrificielle (48) ; et une partie de la deuxième couche sacrificielle (47) est retirée par gravure après avoir retiré la première couche sacrificielle (48) par gravure et le dispositif d'ancrage (37) est formé entre la surface inférieure de l'extrémité distale de la partie formant poutre (36a) et la surface du substrat semi-conducteur (32) à partir de la deuxième couche sacrificielle (47) restante et de la couche d'ancrage (37b).

2. Procédé de fabrication du capteur acoustique (31) selon la revendication 1, **caractérisé en ce que** la première couche sacrificielle (48) est formée dans une région excluant la surface inférieure de l'extrémité distale de la partie formant poutre (36a) et autre qu'au moins l'extrémité distale de la partie formant poutre (36a) lorsqu'elle est vue dans une direction perpendiculaire à la surface du substrat semi-conducteur (32) .

3. Procédé de fabrication du capteur acoustique (31) selon la revendication 1, **caractérisée en ce que**
le substrat semi-conducteur (32) est un substrat en silicium ; et
la première couche sacrificielle (48) est du silicium polycristallin ou du silicium amorphe.

4. Procédé de fabrication du capteur acoustique (31) selon la revendication 1, **caractérisé en ce que**
le substrat semi-conducteur (32) est un substrat en silicium ; et
la deuxième couche sacrificielle (47) est un film de dioxyde de silicium ou un film de nitrure de silicium.

5. Capteur acoustique (31) comprenant
un substrat semi-conducteur (32) avec une chambre arrière (35),
un film mince de vibration (36b) agencé sur un côté supérieur du substrat semi-conducteur (32),
un dispositif d'ancrage (37) agencé sur une surface supérieure du substrat semi-conducteur (32),
une partie formant poutre (36a) s'étendant d'un seul tenant à partir du film mince de vibration (36b) et ayant une extrémité distale supportée par le dispositif d'ancrage (37), et
une plaque arrière (34) fixée à la surface supérieure du substrat semi-conducteur (32) pour recouvrir le film mince de vibration (36b) et la partie formant poutre (36a) avec un espace,
une vibration acoustique détectée par le film mince de vibration (36b) étant convertie en un changement de capacitance électrostatique entre un film d'électrode fixe (40) agencé sur la plaque arrière (34) et le film mince de vibration (36b), dans lequel
le dispositif d'ancrage (37) comprend une couche d'ancrage inférieure (37a) réalisée à partir d'un matériau non conducteur agencé sur la surface supérieure du substrat semi-conducteur (32), une couche d'ancrage supérieure (37c) réalisée à partir d'un matériau non conducteur agencé sur la surface inférieure de l'extrémité distale de la partie formant poutre (36a), et une couche d'ancrage centrale (37b) qui est formée à partir d'un matériau différent de celui de la couche d'ancrage supérieure (37c) et de la couche d'ancrage inférieure (37a), et qui est intercalée entre la couche d'ancrage supérieure (37c) et la couche d'ancrage inférieure (37a).

6. Capteur acoustique (31) selon la revendication 5, **caractérisé en ce que**
le substrat semi-conducteur (32) est un substrat en silicium ; et
la couche d'ancrage centrale (37b) est du silicium polycristallin ou du silicium amorphe.

7. Capteur acoustique (31) selon la revendication 5, **caractérisé en ce que**
le substrat semi-conducteur (32) est un substrat en silicium ; et
la couche d'ancrage inférieure (37a) et la couche d'ancrage supérieure (37c) sont un film de dioxyde de silicium ou un film de nitrure de silicium.

## FIG. 1A

## FIG. 1B

FIG. 2A

FIG. 2B

FIG. 2C

FIG. 2D

FIG. 3A

FIG. 3B

FIG. 3C

*FIG. 4A*

*FIG. 4B*

*FIG. 4C*

## FIG. 5A

## FIG. 5B

## FIG. 6

EP 2 384 026 B1

## FIG. 7

# FIG. 8

## FIG. 9A

## FIG. 9B

## FIG. 9C

FIG. 10A

FIG. 10B

FIG. 10C

FIG. 10D

FIG. 11A

FIG. 11B

FIG. 11C

FIG. 12A

FIG. 12B

FIG. 12C

*FIG. 13A*

*FIG. 13B*

*FIG. 13C*

## FIG. 14A

## FIG. 14B

## FIG. 14C

## FIG. 15A

## FIG. 15B

## FIG. 15C

*FIG. 16A*

*FIG. 16B*

*FIG. 16C*

## FIG. 17A

## FIG. 17B

FIG. 18A

FIG. 18B

EP 2 384 026 B1

## FIG. 19A

## FIG. 19B

## FIG. 19C

## FIG. 20A

## FIG. 20B

## FIG. 20C

## FIG. 21A

## FIG. 21B

*FIG. 22A*

*FIG. 22B*

EP 2 384 026 B1

*FIG. 23A*

*FIG. 23B*

FIG. 24A

FIG. 24B

FIG. 24C

*FIG. 25*

*FIG. 26A*

*FIG. 26B*

EP 2 384 026 B1

**EP 2 384 026 B1**

**Patent documents cited in the description**

- JP 2009089097 A

- US 20100038734 A1